(19) Europäisches Patentamt
European Patent Office
Office européen des brevets

(11) Veröffentlichungsnummer: **0 371 924 A2**

(12) # EUROPÄISCHE PATENTANMELDUNG

(21) Anmeldenummer: **89810888.1**

(22) Anmeldetag: **21.11.89**

(51) Int. Cl.[5]: **H05K 3/34, G03F 7/00, G03F 7/11**

(30) Priorität: **29.11.88 GB 8827847**

(43) Veröffentlichungstag der Anmeldung: **06.06.90 Patentblatt 90/23**

(84) Benannte Vertragsstaaten: **BE CH DE FR GB IT LI NL SE**

(71) Anmelder: **CIBA-GEIGY AG**
**Klybeckstrasse 141**
**CH-4002 Basel(CH)**

(72) Erfinder: **Banks, Christopher Paul, Dr.**
**105, Ross Close Saffron Walden**
**Essex CB11 4DU(GB)**
Erfinder: **Irving, Edward, Dr.**
**41, Swaffham Road**
**Burwell Cambridge CB5 0AN(GB)**

(54) **Verfahren zur Herstellung eines Musters.**

(57) Ein Verfahren zur Herstellung eines Musters aus einem elektrisch leitfähigen Material, gekennzeichnet durch

(i) galvanisches Abscheiden eines Filmes enthaltend ein photohärtbares organisches Harz auf eine elektrisch leitende Oberfläche,

(ii) Ausbilden eines vorbestimmten Musters eines Resists auf dem galvanisch abgeschiedenen Film, welches beim Belichten mit aktinischen Strahlen mit den darunterliegenden Bereichen des galvanisch abgeschiedenen Filmes zusammengehärtet wird, und wobei vorbestimmte Bereiche des galvanisch abgeschiedenen Filmes vom Resist unbedeckt bleiben.

(iii) Entfernen der unbedeckten Bereiche des galvanisch abgeschiedenen Filmes durch Behandeln mit einem Lösungsmittel dafür, wobei eine Oberfläche entsteht, die in vorbestimmten Bereichen freiliegendes leitfähiges Material aufweist und in anderen vorbestimmten Bereichen den photogehärteten Resist enthält, der durch den dazwischenliegenden, in bestimmten Bereichen galvanisch abgeschiedenen Film fest mit dem leitfähigen Material verbunden ist.

Das Verfahren ist zur Herstellung von gedruckten Schaltungen geeignet.

EP 0 371 924 A2

# Verfahren zur Herstellung eines Musters

Die vorliegende Erfindung betrifft ein Verfahren zur Herstellung eines Musters aus einem elektrisch leitfähigen Material, insbesondere die Herstellung metallischer Muster, wie gedruckte Schaltungen.

Bei der Herstellung gedruckter Schaltungen ist es bekannt, auf der elektrisch leitfähigen Seite, üblicherweise auf die Kupferseite eines kupferkaschierten Laminates, ein Muster aus einem Resist mittels Siebdruck oder Photoabbildungsverfahren aufzutragen. Dabei erhält man ein Laminat, das an einigen Stellen freies Kupfer aufweist, während die anderen Stellen des Kupfers mit dem Resist zugedeckt sind. Je nach Typ der gedruckten Schaltung wird das Laminat verschieden weiterverarbeitet. Beispielsweise kann man das freigelegte Kupfer durch Kontakt mit geschmolzenem Lötmetall bedecken, wobei der Resist als Lötstoppmaske dient. In einem anderen Verfahren wird das freigelegte Kupfer mit einer Zinn-Bleilegierung plattiert, der Resist dann entfernt und das so freigelegte Kupfer mit einem Aetzmittel geätzt, welches die Zinn-Bleilegierung nicht entfernt, die dann mit einem Entmetallisierungsbad entfernt wird, wobei ein Kupfermuster auf dem Laminat zurückbleibt. Dieses Kupfermuster kann weiterverarbeitet werden, indem man darauf einen weiteren Resist in einem unbestimmten Muster aufbringt, der als Lötstoppmaske dient. Das Laminat wird dann mit geschmolzenem Lötmetall so in Kontakt gebracht, dass das freiliegende Kupfer bedeckt wird. Bei beiden Verfahren wird ein Lötmetall eingesetzt, wobei das ein bestimmtes Muster aus einer Lötstoppmaske aufweisende Substrat mit geschmolzenem Lötmetall bei hohen Temperaturen, beispielsweise 200-500° C, kontaktiert wird. Von der Lötstoppmaske wird daher eine gute Haftfestigkeit zum Substrat gefordert. Es liegt somit ein Bedarf nach Verfahren vor, welche eine verbesserte Haftung der Lötstoppmaske auf dem leitfähigen Material bewirken.

Es wurde nun gefunden, dass festere Bindungen zwischen der Lötstoppmaske und dem leitfähigen Substrat bei der Herstellung von Mustern aus einem elektrisch leitfähigen Material dadurch erreicht werden kann, indem man einen photohärtbaren Lötstoppmaskenresist verwendet und vor seiner Applikation auf dem leitfähigen Substrat galvanisch ein photohärtbares Harz abscheidet, das mit dem Lötstoppmaskenresist in vorbe stimmten Bereichen beim Bestrahlen mit aktinischem Licht zusammengehärtet werden kann. Die nicht mit dem photogehärteten Resist bedeckten Bereiche des galvanisch abgeschiedenen Filmes können dann mit einem geeigneten Lösungsmittel entfernt werden, wobei eine Oberfläche erhalten wird, die in vorbestimmten Bereichen das leitfähige Material und ein vorbestimmtes Muster aus dem photogehärteten Resist aufweist, welcher durch den galvanisch abgeschiedenen Film fest mit dem Substrat verbunden ist.

Das galvanische Abscheiden eines Polymerfilmes auf freiliegende Metall eines Substrats, das freiliegendes Metall in vorbestimmten Bereichen aufweist, während die übrigen Bereiche mit einem Resist beschichtet sind, anschliessendes Entfernen des Resists, Ätzen des freigelegten Metalls und Entfernen des galvanisch abgeschiedenen Polymers mit einem geeigneten Lösungsmittel, wobei ein Metallmuster erhalten wird, wird im SU-Patent 293 312, im US-Patent 4 746 399 und in den EP-A-0 255 557 und 0 261 301 beschrieben. In keiner dieser Publikationen wird die Bildung eines Musters auf dem Substrat, das durch Zusammenhärten des Resists mit dem galvanisch abgeschiedenen Polymerfilm erhalten wird, offenbart.

Die vorliegende Erfindung betrifft daher ein Verfahren zur Herstellung eines Musters aus einem elektrisch leitfähigen Material, gekennzeichnet durch

(i) galvanisches Abscheiden eines Filmes enthaltend ein photohärtbares organisches Harz auf eine elektrisch leitende Oberfläche,

(ii) Ausbilden eines vorbestimmten Musters eines Resists auf dem galvanisch abgeschiedenen Film, welches beim Belichten mit aktinischen Strahlen mit den darunterliegenden Bereichen des galvanisch abgeschiedenen Filmes zusammengehärtet wird, und wobei vorbestimmte Bereiche des galvanisch abgeschiedenen Filmes vom Resist unbedeckt bleiben und

(iii) Entfernen der unbedeckten Bereiche des galvanisch abgeschiedenen Filmes durch Behandeln mit einem Lösungsmittel dafür, wobei eine Oberfläche entsteht, die in vorbestimmten Bereichen freiliegendes leitfähiges Material aufweist und in anderen vorbestimmten Bereichen den photogehärteten Resist enthält, der durch den dazwischenliegenden, in bestimmten Bereichen galvanisch abgeschiedenen Film fest mit dem leitfähigen Material verbunden ist.

Da das im Schritt (i) abgeschiedene photohärtbare Harz und das in Schritt (ii) gebildete Resistmuster zusammengehärtet werden, müssen sie beim Belichten mit aktinischen Strahlen nach dem gleichen Mechanismus gehärtet werden können. Beispielsweise können der galvanisch abgeschiedene Film und der Resist beide durch freie Radikale in Gegenwart eines freien Radikal-Photopolymerisationsinitiators gehärtet werden. Ausserdem können der galvanisch abgeschiedene Film und der Resist beide photovernetzt werden durch direkte Aktivierung der lichtempfindlichen Gruppen mittels Bestrahlung. Ferner ist es möglich, den galvanisch abgeschiedenen Film mit dem Resist zusammen durch kationische Polymerisation in Gegenwart

eines kationischen Photopolymerisationsinitiators zu härten.

Als Resist geeignete Verbindungen, welche mittels Bestrahlung mit aktinischen Strahlen durch direkte Aktivierung der photoempfindlichen Gruppen vernetzt werden können, sind bekannt. Solche sind beispielsweise filmbildende Harze mit Stilben-, Maleinimido-, Chalcon-, Propenon-, Pentadienon- oder Cinnamatgruppen. Diese Harze können als Resist in Stufe (ii) des erfindungsgemässen Verfahrens eingesetzt werden, wenn Harze mit gleichartigen co-vernetzbaren Gruppen und ein Salz bildenden Gruppen als galvanisch abgeschiedenes Harz in Stufe (i) verwendet werden. Die galvanisch abscheidbaren Harze können sich von den Harzen, die als Resist verwendet werden, ableiten, indem in diese mittels bekannter Verfahren Salze bildende Gruppen eingeführt werden. Beispielsweise, wenn ein als Resist verwendetes Harz neben photoempfindlichen Gruppen eine Epoxidgruppe enthält, kann diese mit einem sekundären Amin oder einer Polycarbonsäure umgesetzt werden, wobei eine tertiäre Aminogruppe oder eine Carboxylgruppe eingeführt wird. Wenn das als Resist verwendete Harz eine Hydroxylgruppe enthält, kann diese beispielsweise mit einer Polycarbonsäure umgesetzt werden, wobei in das Harz eine Carboxylgruppe eingeführt wird.

Weisen die beim erfindungsgemässen Verfahren verwendeten galvanisch abgeschiedenen Harzfilme und Resists direkt aktivierbare photoempfindliche Gruppen auf, so enthalten diese vorzugsweise Harze mit einer $\alpha,\beta$-ethylenisch ungesättigten Ester- oder Ketongruppe, wobei die aromatischen oder ethylenisch ungesättigten Doppelbindungen in Konjugation mit der $\alpha,\beta$-Doppelbindung stehen. Als Salz bildende Gruppe weisen die galvanisch abgeschiedenen Filme vorzugsweise eine Carboxyl- oder Aminogruppe auf. Beispielsweise kann der galvanisch abgeschiedene Film ein Addukt aus einem Epoxidharz und Zimtsäure oder Sorbinsäure enthalten, welches durch Umsetzung der sekundären Hydroxylgruppen mit Polycarbonsäureanhydriden, wie Adipin- oder Glutarsäureanhydrid, modifiziert wurde, um Carboxylgruppen in das Molekül einzuführen, und kann der Resist ein Polyvinylcinnamat oder ein Addukt aus einem Epoxidharz und Zimtsäure enthalten. Wenn der galvanisch abgeschiedene Film und der Resist Harze enthalten mit konjugierten $\alpha,\beta$-Doppelbindungen, enthält der galvanisch abgeschiedene Film vorzugsweise ein Umsetzungsprodukt aus einem Epoxidharz enthaltend eine $\alpha,\beta$-ethylenisch ungesättigte Ketongruppe, worin die aromatischen oder ethylenischen Doppelbindungen in Konjugation zur $\alpha,\beta$-Doppelbindung stehen, und einem sekundären Monoamin. Der Resist enthält vorzugsweise ein Epoxidharz mit einer solchen konjugierten ungesättigten Ketongruppe. Das als Resist verwendete Epoxidharz, von welchem sich das galvanisch abgeschiedene Harz ableitet, kann beispielsweise eine Chalcon- oder phenylsubstituierte Propenongruppe oder vorzugsweise wenigstens eine 1,5-Diphenylpenta-1,4-dien-3-on-Gruppe enthalten. Als solche Epoxidharze sind besonders bevorzugt der Polyglycidylether von 1,5-bis-(Hydroxyphenyl)-penta-1,4-dien-3-on und die daraus durch Vorverlängerung erhaltenen Produkte mit einem Bisphenol, vorzugsweise Bisphenol A und/oder Tetrabrombisphenol A, oder einem Hydantoin, vorzugsweise 5,5-Dimethylhydantoin, oder Vorverlängerungsprodukte aus einem Bisphenoldiglycidylether oder einem N,N-Diglycidylhydantoin mit einem Bis-(hydroxyphenyl)-penta-1,4-dien-3-on.

Umsetzungsprodukte von solchen konjugierten ungesättigten Ketongruppen aufweisenden Epoxidharzen mit sekundären Monoaminen sind für die Verwendung als galvanisch abscheidbares, photohärtbares Harz in der Literatur noch nicht beschrieben worden. Sie können unter Anwendung üblicher Herstellungsverfahren, beispielsweise durch Erhitzen der Ausgangsstoffe in einem inerten Lösungsmittel bei 50-120 °C, hergestellt werden. Als sekundäre Monoamine eignen sich beispielsweise ein Dialkylamin, Diethylamin, Di-n-propylamin, Diisopropylamin, Di-n-butylamin, Diisobutylamin, Di-n-amylamin, Diisoamylamin, Di-n-hexylamin, Di-n-octylamin und Di-n-dodecylamin, ein Alkanolamin, wie Diethanolamin, N-Methylethanolamin, N-Butylethanolamin, Diisopropanolamin, N-Ethylisopropanolamin oder Di-n-butanolamin, sowie ein N-Heterocyclus, wie Piperidin oder Morpholin. Alkanolamine werden bevorzugt eingesetzt.

Bevorzugte galvanisch abscheidbare, photohärtbare Harze entsprechen der Formel I

$R_1[CH_2CH(OH)CH_2N(R_2)R_3]_2$ (I),

worin $R_1$ einen Rest eines Epoxidharzes nach Entfernen von zwei Epoxidgruppen darstellt, der eine $\alpha,\beta$-ethylenisch ungesättigte Ketongruppe enthält und worin die aromatische und ethylenische Doppelbindung in Konjugation zur $\alpha,\beta$-Doppelbindung stehen, vorzugsweise einen 1,5-Bis-(oxyphenyl)-penta-1,4-dien-3-on-Rest darstellt, beispiels weise einen Rest der Formel II

$-O-Ar_1-CH=CH-CO-CH=CH-AR_1-O-$ (II),

worin $Ar_1$ einen unsubstituierten oder substituierten Phenylenrest bedeutet und $R_2$ und $R_3$ je ein $C_1$-$C_{12}$-Alkyl bedeuten, das gegebenenfalls durch eine Hydroxylgruppe substituiert ist, oder $R_2$ und $R_3$ zusammen mit dem angegebenen N-Atom einen 5- oder 6-gliedrigen heterocyclischen Ring darstellen.

In den bevorzugten Harzen der Formel I bedeuten $R_1$ einen Rest der Formel III oder IV

$\{\{XCH_2CH(OH)CH_2)_m-(YCH_2CH(OH)CH_2)_n\}_p-X-$ (III) oder

$\{\{YCH_2CH(OH)CH_2)_n-(XCH_2CH(OH)CH_2)_m\}_p-Y-$ (IV),

und $R_2$ und $R_3$ je ein hydroxylsubstituiertes Alkyl mit 2-4 C-Atomen, worin in Formel III und IV

X einen Rest der Formel II darstellt, in dem $Ar_1$ für einen unsubstituierten Phenylenrest steht,
Y einen Rest der Formel V oder VI
$-O-Ar_2-R_4-Ar_2-O-$ (V) oder

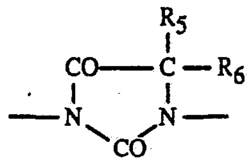

(VI)

darstellt, worin
$Ar_2$ einen unsubstituierten oder substituierten Phenylenrest, vorzugsweise einen unsubstituierten oder halogensubstituierten Phenylenrest,
$R_4$ ein Alkylen mit 1-3 C-Atomen,
$R_5$ und $R_6$ ein Wasserstoffatom oder ein Alkyl mit 1-4 C-Atomen und
m, n und p positive Zahlen bedeuten, so dass das Harz ein durchschnittliches Molekulargewicht von 500 bis 10000 aufweist. Die Harze der Formel I können hergestellt werden, indem man ein Epoxidharz der Formel VII

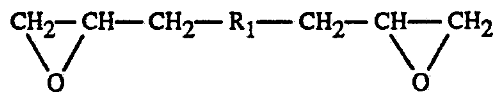

(VII)

mit einem sekundären Monoamin der Formel VIII
$HN(R_2)R_3$ (VIII),
worin $R_1$, $R_2$ und $R_3$ die oben genannte Bedeutung haben, unter für Epoxid-Amin-Reaktionen üblichen Bedingungen umsetzt.

Epoxidharze der Formel VII, worin $R_1$ einen Rest der Formel III darstellt, können durch Vorverlängerung eines Epoxidharzes der Formel IX

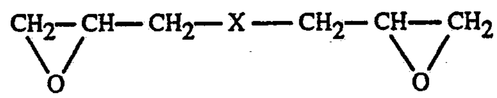

(IX)

mit einer Verbindung der Formel X
H-Y-H (X),
worin X und Y die oben genannte Bedeutung haben, unter für Vorverlängerungsreaktionen üblichen Bedingungen durchgeführt werden.

Desgleichen können Epoxidharze der Formel VII, worin $R_1$ einen Rest der Formel IV darstellt, durch übliche Vorverlängerungsreaktion eines Epoxidharzes der Formel XI

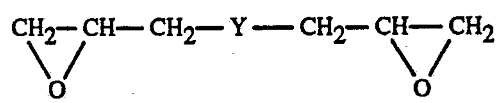

(XI)

mit einem Bisphenol der Formel XII
H-X-H (XII),
worin X und Y die oben genannte Bedeutung haben, hergestellt werden.

Als geeignete Epoxidharze der Formeln IX und XI, Bisphenole oder Hydantoine der Formel X, Bisphenole der Formel XII und Amine der Formel VIII können die zuvor genannten eingesetzt werden.

Galvanisch abgeschiedene Harze, welche durch eine freie Radikale-Polymerisation härtbar sind, enthalten vorzugsweise polymerisierbare Acrylatgruppen zusammen mit einer Salz bildenden Gruppe, insbesondere einer Carboxyl- oder tertiären Aminogruppe. Solche Harze können eingesetzt werden, wenn der Resist eine Verbindung enthält, die mittels freier Radikale polymerisierbar ist. Solche galvanisch abscheidbare Harzfilme sind bekannt. Sie enthalten beispielsweise Reaktionsprodukte von Polycarbonsäureanhydriden,

wie Adipin- oder Glutarsäureanhydrid, mit Epoxidharzaddukten, wie aus einem Diglycidylether des Bisphenols A und (Meth)acrylsäure.

Bevorzugte durch freie Radikale photopolymerisierbare, galvanisch abgeschiedene Harzfilme enthalten eine Mischung aus einem Polymer mit Salz bildenden Gruppen, vorzugsweise einer Carboxyl- oder tertiären Aminogruppe, und einer im Durchschnitt mehr als eine polymerisierbare Acrylatgruppe im Molekül aufweisenden Verbindung. Bevorzugte Mischungen dieser Art sind Mischungen aus einem Acrylatpolymer mit Carboxyl-und/oder tertiären Aminogruppen und einem Monomer mit mindestens zwei (Meth)-acrylatgruppen. Geeignete Acrylatpolymere sind beispielsweise Homopolymere aus Acrylatmonomeren mit einer Carboxyl- oder tertiären Aminogruppe, wie Acryl- oder Methacrylsäure, Addukte aus einem Hydroxyalkylacrylat oder Hydroxyalkylmethacrylat mit einem Polycarbonsäureanhydrid, Dialkylaminoalkylacrylat oder Dialkylaminoalkylmethacrylat, und Copolymere aus solchen Monoacrylatmonomeren mit anderen oder mit einem keine Carboxyl- oder Aminogruppen aufweisenden Monoacrylsäureester, gegebenenfalls zusammen mit wenigstens einem Vinylmonomer.

Acrylsäure und Methacrylsäure sind die besonders bevorzugten Carboxylgruppen aufweisende Monoacrylsäuremonomere. Ein besonders bevorzugtes Monoacrylsäuremonomer mit tertiärer Aminogruppe ist das 2-(Dimethylamino)-ethylmethacrylat. Für die Copolymerbildung bevorzugte carboxyl- und aminogruppenfreie Monoacrylsäureester sind beispielsweise Alkylacrylate, Alkylmethacrylate, Hydroxyalkylacrylate, Hydroxyalkylmethacrylate, wie Methylacrylat, Ethylacrylat, n-Butylacrylat, n-Hexylacrylat, 2-Ethylhexylacrylat, 2-Hydroxyethylacrylat, 2-Hydroxypropylacrylat, 3-Hydroxypropylacrylat und die entsprechenden Methacrylate. Als bestes Vinylmonomer, welches für die Copolymerbildung eingesetzt werden kann, eignet sich beispielsweise ein Vinylester, wie Vinylacetat, ein Vinylhalogenid, wie Vinylchlorid, oder vorzugsweise ein Styrol, wie Styrol selbst, α-Methylstyrol oder p-Chlorstyrol, während Styrol besonders bevorzugt ist.

Die Acrylatpolymere können nach bekannten Polymerisationsverfahren unter Verwendung von freien Radikalepolymerisationsinitiatoren, wie Peroxide oder Azoverbindungen, hergestellt werden, wobei gewöhnlich Polymere mit einem durchschnittlichen Molekulargewicht von 5000 und mehr, vorzugsweise von 5000 bis 50000, erhalten werden. Beispielsweise können die Monomeren in Gegenwart des Initiators in einem organischen Lösungsmittel, vorzugsweise einem Lösungsmittel, welches mit dem Medium, aus welchem das Polymer galvanisch abzuscheiden ist, mischbar ist. Gewünschtenfalls können dabei übliche Kettenübertragungsreagentien, wie tert.-Dodecylmercaptan, eingesetzt werden.

Als Verbindungen, welche durchschnittlich mehr als eine polymerisierbare Acrylatgruppe im Molekül aufweisen und für Gemische mit Acrylatpolymere zur Herstellung von galvanisch abgeschiedenen Filmen geeignet sind, kommen beispielsweise Acrylsäureester oder Methacrylsäureester oder ein Carboxylgruppen aufweisendes Addukt aus einem Hydroxyalkylacrylat, -methacrylat oder einem Polycarbonsäureanhydrid und einem mehrwertigen Alkohol, welcher niedermolekular sein kann, oder ein filmbildendes Harz, oder einem Epoxidharz, in Frage. Ferner sind Urethanacrylate, d.h., Reaktionsprodukte von isocyanatterminierten Polyurethanprepolymeren mit einem Hydroxyalkylacrylat oder Hydroxyalkylmethacrylat geeignet. Als bevorzugt polymerisierbare Acrylate werden die Monomeren mit wenigstens zwei Acrylat- bzw. Methacrylatgruppen eingesetzt, insbesondere Ester von (Meth)acrylsäure mit mehrwertigen Alkoholen, die 2 bis 6 Hydroxylgruppen aufweisen, wie aliphatische mehrwertige Alkohole mit bis zu 12 C-Atomen, beispielsweise Ethylenglykol, Propylen-1,2-diol, Trimethylenglykol, Tetramethylenglykol, Neopentylglykol, Hexamethylenglykol, Okta- und Dodekamethylenglykol und Oxyalkylenglykole, wie Di-, Tri- und Tetra-(oxyalkylen)-glykol und Tri-(oxypropylen)-glykol, Triole, wie Glycerin oder 1,1,1-Trimethylolpropan und Tetrole, wie Erythrit und Pentaerythrit; cycloaliphatische mehrwertige Alkohole, wie di- oder trihydroxymethylsubstituierte Cyclohexane, heterocyclische mehrwertige Alkohole, wie Tris-(2-hydroxyethyl)-isocyanurat; aromatische mehrwertige Alkohole, wie Dimethylol- und Trimethylolbenzole und 2,2-Bis-(p-(2-hydroxyethoxy)-phenyl)-propan. Viele dieser (Meth)acrylate sind im Handel erhältlich. Die anderen können nach bekannten Verfahren hergestellt werden, beispielsweise durch Veresterung eines mehrwertigen Alkohols mit (Meth)acrylsäure oder einem Esterderivat, wie Acryloylchlorid oder Methacryloylchlorid.

Wenn der galvanisch abgeschiedene Film polymerisierbare Acrylatgruppen enthält, sind im Resist vorzugsweise Verbindungen enthalten, die durchschnittlich mehr als eine polymerisierbare Acrylatgruppe im Molekül enthalten. Ferner sind solche Verbindungen geeignet, die Epoxid- und (Meth)acrylatgruppen enthalten wie sie im US-Patent 4 548 895 beschrieben werden. Als Resist sind auch photohärtbare Addukte aus Epoxidharzen mit (Meth)acrylsäure geeignet, welche bekannt und grösstenteils im Handel erhältlich sind. Der Resist ist vorzugsweise in wässrigem Alkali entwickelbar und enthält eine Verbindung mit polymerisierbaren Acrylatgruppen und wenigstens einer Carboxylgruppe.

Solche Verbindungen sind im GB-Patent 1 474 715 beschrieben. Bevorzugte, in wässrigem Alkali entwickelbare Resists mit Acrylat- und Carboxylgruppen sind die von Du Pont unter der Handelsbezeichnung RISTON® erhältlichen.

Wenn der galvanisch abgeschiedene Harzfilm und der Resist eine durch freie Radikale polymerisierbare Verbindung enthält, muss entweder der galvanisch abgeschiedene Film oder der Resist einen freien Radikale-Polymerisationsinitiator enthalten. Vorzugsweise enthalten beide einen solchen Initiator. Geeignete Photoinitiatoren sind bekannt und im Handel erhältlich. Sie werden in üblichen Mengen im allgemeinen von 0,1 bis 20 Gew.-%, vorzugsweise von 1 bis 10 Gew.-%, bezogen auf das polymerisierbare Material, eingesetzt.

Die Photopolymerisationsinitiatoren können eine aromatische Carbonylverbindung, beispielsweise ein Benzoin, ein Benzoinalkylether, wie Isopropyl- oder n-Butylether, ein α-substituiertes Acetophenon, beispielsweise ein Benzildialkylketal, wie Benzildimethylketal, ein α-Haloacetophenon, wie Trichlormethyl-p-tert.-butylphenylketon, ein α-Aminoacetophenon, wie Dimethylaminomethylphenylketon und Morpholinmethylphenylketon, ein Dialkoxyacetophenon, wie Diethoxyacetophenon, oder ein α-Hydroxyacetophenon, wie 1-Hydroxycyclohexylphenylketon oder ein Benzophenon, wie Benzophenon selbst und Bis-(4-dimethylamino)-benzophenon, ein Metallocen, beispielsweise ein Titanium-metallocen, wie Bis-(π-methylcyclopentadienyl)-bis-(σ-pentafluorphenyl)-titanium (IV), eine organometallische Verbindung der Gruppe IVA, beispielsweise ein Stannan, wie Trimethylbenzylstannan, Tributylbenzylstannan oder Dibutylbenzylstannan, zusammen mit einem photoreduzierbaren Farbstoff, wie Methylenblau oder Rosabengal; ein Chinon, wie Anthrachinon oder Kampferchinon zusammen mit einem Amin, das am aliphatischen α-Kohlenstoffatom Wasserstoffatome aufweist, vorzugsweise ein tertiäres Amin, wie Bis-(4-dimethylamino)-benzophenon und Triethanolamine, ein Thioxanthon, beispielsweise ein alkyl- oder halogensubstituiertes Thioxanthon, wie 2-Isopropylthioxanthon oder 2-Chlorthioxanthon, ein Acylphosphinoxid, oder ein Gemisch von zwei oder mehreren solcher Verbindungen.

Wenn der Resist eine kationisch polymerisierbare Verbindung zusammen mit einem kationischen Photoinitiator enthält, kann der galvanisch abgeschiedene Harzfilm epoxid-und salzbildende Gruppen enthalten, wie vorzugsweise eine tertiäre Aminogruppe. Solche Harze sind beispielsweise durch Umsetzung eines sekundären Monoamins mit einem Teil der Glycidylgruppen eines Copolymers aus Glycidyl(meth)-acrylaten und mindestens einem anderen Vinylmonomer, wie Alkylacrylat, Hydroxyalkylacrylat oder Styrol, erhältlich.

Kationisch photohärtbare Gemische, welche als Resist geeignet sind, sind bekannt. Vorzugsweise enthalten solche Gemische ein Epoxidharz mit einem Oniumsalz, Metallocensalz oder ein aromatisches Jodosylsalz. Solche härtbaren Gemische werden im US-Patent 4 572 890 und in der EP-A-0 094 915 offenbart. Als Epoxidharz enthalten die Gemische vorzugsweise einen Polyglycidylether eines mehrwertigen Phenols, wie Phenol-Formaldehyd-Novolak oder vorzugsweise Bisphenol, insbesondere Bisphenol A, oder ein cycloaliphatisches Epoxidharz, wie Vinylcyclohexendioxid oder vorzugsweise 3,4-Epoxycyclohexylmethyl-3′,4′-epoxycyclohexancarboxylat, oder eine Mischung solcher Epoxidharze. Als kationischer Photoinitiator wird vorzugsweise ein Sulphonium- oder Sulphoxoniumsalz eingesetzt.

Die erfindungsgemäss zu verwendenden Harzfilme und Resists können ausserdem Photosensibilisatoren oder andere übliche Additive enthalten, wie beispielsweise Farbstoffe oder photounempfindliche Filmbildungsmittel.

Die Galvanoplattierung des Harzfilmes in Stufe (i) des erfindungsgemässen Verfahrens kann nach bekannten Verfahren durchgeführt werden, beispielsweise von wässrigen galvanischen Lösungen enthaltend das photohärtbare organische Harz in wenigstens teilweise ionisierter Form. Das galvanisch abscheidbare Harz kann, gegebenenfalls zusammen mit Pigmenten, Farbstoffen, Füllstoffen und Plastifizierungsmittel, in Wasser gelöst oder dispergiert werden, wobei das wässrige Medium geringe Mengen eines organischen Lösungsmittels enthalten kann, sowie eine Säure oder Base, um die salzbildenden Gruppen wenigstens teilweise zu neutralisieren. Gewünschtenfalls können die salzbildenden Gruppen des Harzes auch vor dessen Zugabe zur wässrigen galvanischen Lösung neutralisiert werden. Die wässrige galvanische Lösung enthält im allgemeinen 2 bis 60 Gew.-%, vorzugsweise 5 bis 25 Gew.-% des photohärtbaren organischen Harzes. Die elektrisch leitfähige Oberfläche, auf welche der Harzfilm galvanoplattiert werden soll, kann in die galvanische Lösung eingetaucht und als Anode oder Kathode geschaltet werden, je nachdem das Harz anodisch oder kathodisch abscheidbar ist. Nach Eintauchen einer weiteren Elektrode entgegengesetzter Ladung lässt man Strom zwischen den Elektroden fliessen, wobei das Harz auf der leitfähigen Oberfläche galvanisch abgeschieden wird.

Die Galvanoplattierung kann in wenigen Minuten, normalerweise bis zu 1 Minute bei einer Spannung bis zu 200 V vorgenommen werden. Spannungen von weniger als 2 V können angewendet werden, wenn die Elektrode, auf welche der Harzfilm abgeschieden wird, relativ Klein ist im Vergleich zur anderen Elektrode. Beispielsweise kann ein kathodisch abscheidbares Harz auf einer schmalen Kathode in einem Metalltank, der als Anode geschaltet ist, bei einer Spannung von 2 bis 5 Volt abgeschieden werden. Beispielsweise kann eine gute Galvanoplattierung mit guter Haftfestigkeit dadurch erreicht werden, indem man das Harz 2

Minuten bei 2 V und anschliessend 5 Minuten bei 5 V galvanisch abscheidet.

Der Schritt (ii) des erfindungsgemässen Verfahrens kann durchgeführt werden, indem man

(a) eine Schicht von einem Resist über den galvanisch abgeschiedenen Film aufbringt,

(b) die Resistschicht mit aktinischem Licht in vorbestimmtem Muster bestrahlt, wobei der Resist und der darunter liegende, galvanisch abgeschiedene Film in den bestrahlten Bereichen photogehärtet werden, und

(c) die nichtbestrahlten Bereiche der Resistschicht entfernt.

Die Bestrahlung der photohärtbaren Resistschicht in einem vorbestimmten Muster kann durch Bestrahlung durch ein bildtragendes Dia erfolgen, das aus im wesentlichen undurchlässigen und aus im wesentlichen durchlässigen Flächenanteilen besteht. Die Bestrahlung kann auch vermittels eines computergesteuerten Laserstrahls erfolgen.

In der Regel verwendet man elektromagnetische Strahlung im Wellenlängenbereich von 200-600 nm. Geeignete Strahlungsquellen umfassen Kohlelichtbögen, Quecksilberdampflampen, Leuchtstoffröhren mit UV-Licht emittierenden Leuchtstoffen, Argon- und Xenon-Glimmlampen, Wolframlampen oder photographische Flutlichtlampen.

Bevorzugt werden Quecksilberdampflampen und Metallhalogenidlampen. Die notwendige Belichtungszeit hängt von mehreren Faktoren ab, beispielsweise von der Natur und der Dicke der Komponenten der Photoresistschicht, der Art der Strahlungsquelle und deren Abstand von der Lötstoppmaske. Die fallweise notwendigen Belichtungszeiten können anhand von Routinetests ermittelt werden.

Die Entfernung der unbestrahlten Bereiche der Resistschicht wird vorzugsweise durch Behandlung mit einem Lösungsmittel durchgeführt. Dieses wird in der Natur des Photoresists entsprechend ausgewählt. Es kann sich dabei um Wasser handeln, um eine wässrige oder wässrig-organische Lösung einer Säure oder Base oder um ein organisches Lösungsmittel oder um Gemische solcher Lösungsmittel. Geeignete saure Lösungen enthalten beispielsweise Essigsäure, Milchsäure, Glykolsäure oder Toluol-p-sulfonsäuren; geeignete basische Lösungen enthalten beispielsweise Natrium- oder Kaliumhydroxid oder -carbonat.

Geeignete organische Lösungsmittel umfassen Kohlenwasserstoffe, wie Toluol und Xylol, halogenierte Kohlenwasserstoffe, wie 1,1,1-Trichlorethan und Dichlormethan, hydroxylgruppenhaltige Lösungsmittel, wie Ethanol, 2-n-Butoxyethanol oder 2-Ethoxyethanol, Ester, wie 2-Ethoxyethylacetat, Ketone, wie Cyclohexanon, Aceton oder Methylethylketon, und Ether, wie Tetrahydrofuran, und Laktone, wie $\gamma$-Butyrolakton.

Das Lösungsmittel kann so ausgewählt werden, dass die Entfernung der nichtbestrahlten Bereiche des photohärtbaren Resists auch den Schritt (iii) des erfindungsgemässen Verfahrens bewirken, d.h., die Entfernung der unbedeckten Bereiche des galvanisch abgeschiedenen Films. Wenn das zur Entfernung der nichtbestrahlten Bereiche des Photoresists verwendete Lösungsmittel die unbedeckten Bereiche des galvanisch abgeschiedenen Films nicht entfernt, muss für Schritt (iii) ein anderes Lösungsmittel genommen werden. Ein solches Lösungsmittel kann aus der oben genannten Gruppe von Lösungsmitteln ausgewählt werden. Ein geeignetes Lösungsmittel lässt sich durch Routinetests ermitteln.

Das erfindungsgemässe Verfahren ist besonders zur Herstellung von metallischen Mustern geeignet, wobei man von einem Substrat ausgeht, dessen Oberfläche in vorbestimmten Bereichen freiliegendes Metall und in den übrigen Bereichen einen das Metall beschichtenden Resist aufweist. Die freiliegende Metalloberfläche ist die im Schritt (i) des erfindungsgemässen Verfahrens bezeichnete elektrisch leitfähige Oberfläche.

Der als Beschichtung auf dem ursprünglichen Substrat vorgebildete Resist kann ein mittels Siebdruck aufgetragenes Epoxidharz sein, das getrocknet wird. Vorzugsweise ist der vorgebildete Resist, der in ausgewählten Bereichen das Substrat beschichtet, ein Photoresist und das Substrat üblicherweise ein kupferkaschiertes Plastiklaminat. Nach der Bestrahlung mit aktinischen Strahlen in bestimmten Bereichen werden die bestrahlten oder unbestrahlten Bereiche entfernt, je nachdem, ob ein positiv oder negativ arbeitender Resist verwendet wurde. Beide Arten von Resists sind bekannt und werden zur Herstellung von gedruckten Schaltungen eingesetzt. Die Resists können unter wässrigen Bedingungen oder mit Hilfe von organischen Lösungsmitteln entfernt werden. Eine Schicht eines anderen Metalles, wie Zinn-Bleilegierung oder Nickel, kann auf den freiliegenden Kupferbereichen abgeschieden werden, bevor der photohärtbare Film galvanisch abgeschieden wird.

Es ist auch möglich, den vorgebildeten Resist und den galvanisch abgeschiedenen Film so zu kombinieren, dass beide unter wässrig sauren oder wässrig alkalischen Bedingungen entfernbar sind, vorausgesetzt, dass der Photoresist unter milderen Bedingungen entfernbar ist als der galvanisch abgeschiedene Film, beispielsweise mittels einer mehr verdünnten Lösung einer Säure oder Base. Es ist auch möglich, einen vorgebildeten Resist und einen galvanisch abgeschiedenen Film zu verwenden, die mittels verschiedenen organischen Lösungsmitteln entfernbar sind. In einer besonders bevorzugten Ausführungsform verwendet man einen in wässrigem Medium löslichen Resist und entfernt den galvanisch abgeschiedenen Film in Schritt (iii) mit einem organischen Lösungsmittel.

Das durch Entfernen des vorgebildeten Resists freigelegte Metall, gewöhnlich Kupfer, kann mit allen bekannten Ätzemitteln, wie Ferrichlorid, Wasserstoffperoxid/Phosphorsäure, Ammoniumpersulfat oder Kupferchlorid entfernt werden. Nach dem Ätzen weist das Substrat eine Oberfläche auf, die aus vorbestimmten Bereichen des mit dem galvanisch abgeschiedenen Film bedeckten Metalls besteht und solchen vorbestimmten Bereichen, aus denen das Metall durch den Ätzprozess entfernt wurde.

Das erfindungsgemässe Verfahren ist besonders zur Herstellung von gedruckten Schaltungen, auch Mehrlagenleiterplatten mit Verbindungslöchern und Durchkontaktierungen geeignet. Der photogehärtete Resist, der in Schritt (ii) in vorbestimmten Bereichen auf den galvanisch abgeschiedenen Film gebildet wird, kann als Lötstoppmaske für das Verfahren zur Herstellung von gedruckten Schaltungen eingesetzt werden.

Die Erfindung wird durch die folgenden Beispiele näher erläutert, worin Teile und Prozente Gewichtsteile bzw. Gewichtsprozente sind, falls keine andere Angabe gemacht wird.

Die in den folgenden Beispielen verwendeten Harze werden wie folgt hergestellt:

## Harz I

70 Teile einer 50 %-igen Lösung in einem Gemisch aus 2-Ethoxyethylacetat und 2-Methoxyethanol (Gewichtsverhältnis 2:1) eines Epoxidharzes, das durch Vorverlängerung von 1,5-Bis-(4-glycidyloxyphenyl)-penta-1,4-dien-3-on mit Bisphenol A und Tetrabrombisphenol A erhalten wird, ein durchschnittliches Molekulargewicht (Zahlenmittel) von 3400-3500 und einen Epoxidgehalt von 0,8 Äquivalenten/kg aufweist, werden auf 130 °C erhitzt. Man gibt 3,14 Teile Diethanolamin dazu und rührt die Mischung bei 130 °C während 4 Stunden. Danach ist der Epoxidgehalt geringfügig. Dann wird die Mischung auf 90 °C gekühlt und mit 2,16 Teilen einer 20 %-igen wässrigen Milchsäure versehen. Das erhaltene Produkt wird auf Zimmertemperatur gekühlt. Das Harz, das vor der Zugabe von Milchsäure unter Entfernung des Lösungsmittels bei 130 °C im Vakuum erhalten wird, weist folgende Merkmale auf:

Amingehalt: 0,61 Äqu./kg

Erweichungspunkt (Kofler, Heizbank): 105 °C.

IR (KBr disc.) 3420, 3160, 2940, 2880, 1760, 1645, 1602, 1572, 1510, 1455, 1425, 1250, 1171, 1096, 1035, 830, 640 $cm^{-1}$.

MNR (DMSO-$d_6$) 1,1(t), 1,6(s), 2,0(s), 2,5(m), 3,3-4,5(m), 6,8-7,9(m)$\delta$.

## Harz II

Eine Mischung aus 47,5 Teilen Styrol, 25 Teilen 2-Ethylhexylacrylat, 20 Teilen 2-Hydroxyethylmethacrylat und 7,5 Teilen Dimethylaminoethylmethacrylat und 1,5 Teilen Azo-bis-(isobutyronitril) wird tropfenweise zu 50 Teilen 2-n-Butoxyethanol innerhalb von 2 Stunden zugegeben, das unter Stickstoff bei 100 °C gerührt wird. Das Reaktionsgemisch wird für eine weitere Stunde bei 100 °C belassen. Dann werden weitere 0,5 Teile Azo-bis-(isobutyronitril) in 5,5 Teilen 2-n-Butoxyethanol bei 100 °C zugegeben. Dieses Prozedere wird noch zweimal wiederholt. Nach einer weiteren Stunde bei 100 °C wird das Reaktionsgemisch abgekühlt. Das in der Lösung enthaltene Copolymer hat ein durchschnittliches Molekulargewicht (Zahlenmittel) von 10416.

## Harz III

92,6 Teile einer 40 %-igen Lösung eines Epoxidharzes, das durch Vorverlängerung von 1,5-Bis-(4-glycidyloxyphenyl)-penta-1,4-dien-3-on mit 5,5-Dimethylhydantoin erhalten wird und einen Epoxidgehalt von 0,7 bis 1,0 Äqu./kg aufweist, werden in 2-Ethoxyethanol auf 130 °C erhitzt. 2,66 Teile Diisopropanolamin werden dazugegeben und die Mischung wird 5 Stunden bei 130 °C gerührt. Danach ist der Epoxidgehalt vernachlässigbar. Die Mischung wird auf 90 °C gekühlt und mit 1,2 Teilen 20 %iger wässriger Milchsäure versehen. Das erhaltene Reaktionsprodukt wird auf Raumtemperatur gekühlt.

Das Harz, das vor der Zugabe von Milchsäure unter Entfernung des Lösungsmittels bei 130 °C im Vakuum erhalten wird, weist folgende Merkmale auf.

Amingehalt: 0,40 Äqu./kg

Erweichungspunkt: 108 °C

IR (KBr disc.) 3400, 2980, 2940, 2880, 1770, 1710, 1645, 1600, 1571, 1512, 1460,

1425,1255,1171,1095,1031,988,832,640 $cm^{-1}$.
NMR ($DMSO-d_6$) 0,9-1,5(m), 2,5(s), 3,3-4,2(m), 6,8-7,9(m)δ.

Harz IV

Eine Miscung enthaltend 30 Teile Glycidylmethacrylat, 30 Teile Styrol, 5 Teile 2-Hydroxyethylmethacrylat, 35 Teile 2-Ethylhexylacrylat und 1,5 Teile Azo-bis-(isobutyronitril) wird tropfenweise während 2 Stunden zu 50 Teilen 2-n-Butoxyethanol zugegeben, das bei 100 °C gerührt wird. Danach wird das Reaktionsgemisch eine weitere Stunde bei 100 °C belassen und dann werden weitere 0,5 Teile Azo-bis-(isobutyronitril) in 5,5 Teilen 2-n-Butoxyethanol zugegeben. Dieses Prozedere wird noch zweimal wiederholt und nach einer weiteren Stunde bei 100 °C wird das Reaktionsgemisch abgekühlt. Der Amingehalt der erhaltenen Lösung beträgt 0,30 Äqu./kg, der Epoxidgehalt ist 0,85 Äqu./kg und der Feststoffgehalt beträgt 58,6 %.

Der in den Beispielen verwendete Photoresist RISTON® 3415 ist ein wässrig entwickelbarer, negativer, photohärtbare Acrylatgruppen enthaltender trockener Filmresist, der einen Radikale-Photopolymerisationsinitiator enthält, und von der Firma Du Pont (UK) Ltd., Riston Division, Wedgewood Way, Stevenage, Hertfordshire SG1 4QN, England, erhältlich ist.

Der in den Beispielen verwendete Filmabstreifer HOECHST HB 1160 DRY FILM STRIPPER ist von der Firma Hoechst U.K. Ltd., Electronic Products Division, Unit 20, Smiths Industrial Estate, Humber Avenue, Coventry, CV3 1JR, England, erhältlich.

Beispiel 1:

Ein mit dem Photoresist RISTON® 3415 beschichtetes kupferkaschiertes Laminat, welches bildhaft belichtet und entwickelt wurde, wobei im Photoresist ein Muster entstand, wird als Kathode in einem galvanischen Bad verwendet, welches eine Anode aus rostfreiem Stahl und eine Lösung aus 100 Teilen Harz I in einer Mischung aus 339 Teilen Wasser und 48,8 Teilen 2-n-Butoxyethanol enthält. Während 4 Sekunden wird eine Spannung von 55 Volt angelegt. Das Laminat wird dann dem Bad entnommen, mit Wasser abgespült und bei 80 °C während 10 Minuten getrocknet. Der galvanisch abgeschiedene Film bedeckt die Stellen, wo kein Photoresist vorhanden ist und das Kupfer freiliegt. Das Laminat wird dann in eine 7 %-ige wässrige Lösung von Ethanolamin bei 50 °C eingetaucht, wobei der Photoresist entfernt wird und der galvanisch abgeschiedene Film auf dem Laminat bleibt. Das durch Entfernen des Photoresists freigelegte Kupfer wird mittels einer Lösung aus 20 Teilen konz. Schwefelsäure und 150 Teilen Ammoniumpersulfat in 830 Teilen Wasser bei 50 °C weggeätzt. Danach wird das Laminat in Wasser gewaschen und getrocknet. Man erhält in klares Muster, bestehend aus dem auf dem Kupfer galvanisch abgeschiedenen Film, auf dem Laminat. Mittels einer Spiralrakel wird eine Schicht aus dem Epoxidharz, das zur Herstellung von Harz I verwendet wird, als Lötstoppmaske auf das erhaltene Muster aufgetragen. Die Lötstoppmaske wird während 10 Minuten bei 80 °C getrocknet und dann durch eine transparente, ein Bild enthaltende Schablone unter Verwendung einer 5 kW Metallhalogenidlampe im Abstand von 75 cm während 2 Minuten bestrahlt. Durch die Bestrahlung werden die belichteten Teile der Lötstoppmaske und die darunterliegenden Teile des galvanisch abgeschiedenen Filmes zusammengehärtet. Das Laminat wird in eine Mischung aus 50 Teilen Propylencarbonat, 20 Teilen γ-Butyrolakton und 30 Teilen Diethylenglykolmonobutylether eingetaucht, wobei die nichtbelichteten Teile der Lötstoppmaske und die dabei freigelegten Teile des galvanisch abgeschiedenen Filmes herausgelöst werden. Das erhaltene Laminat hat eine Muster aus einer photogehärteten Lötstoppmaske, das mit dem darunter liegenden Kupfermuster durch den dazwischenliegenden gehärteten galvanisch abgeschiedenen Film fest verbunden ist.

Beispiel 2:

Ein mit dem Photoresist RISTON® 3415 beschichtetes kupferkaschiertes Laminat, welches bildhaft belichtet und entwickelt wurde, wobei im Photoresist ein Muster entstand, wird als Kathode in einem galvanischen Bad verwendet, welches eine Anode aus rostfreiem Stahl und eine Lösung aus 101 Teilen Harz III, 6,7 Teilen einer 20%-igen wässrigen Milchsäure, 22,5 Teilen Trimethylolpropantriacrylat und 1,5 Teilen Benzildimethylketal in 469,3 Teilen Wasser. Während 1 Minute wird eine Spannung von 20 Volt angelegt und dann das Laminat aus dem Bad entfernt, in Wasser gespült und während 5 Minuten bei 110 °C getrocknet. Der galvanisch abgeschiedene Film bedeckt die Stellen, wo kein Photoresist ist und das

Kupfer freiliegt. Das Laminat wird dann in eine 7 %-ige wässrige Lösung aus Ethanolamin bei 50°C eingetaucht, wobei der Photoresist entfernt wird und der galvanisch abgeschiedene Film auf dem Laminat bleibt. Das durch Entfernen des Photoresists freigelegte Kupfer wird mittels einer Lösung aus 20 Teilen konz. Schwefelsäure und 150 Teilen Ammoniumpersulfat in 830 Teilen Wasser bei 50°C weggeätzt. Danach wird das Laminat in Wasser gewaschen und getrocknet. Man erhält auf dem Laminat ein Klares Muster bestehend aus dem auf dem Kupfer galvanisch abgeschiedenen Film. Mittels eines Trockenfilmlaminators wird eine Schicht des Photoresists RISTON® 3415 als Lötstoppmaske auf das erhaltene Muster aufgetragen. Der Photoresist wird während 60 Sekunden durch eine transparente, ein Bild enthaltende Schablone unter Verwendung einer 5 kW Metallhalogenidlampe im Anstand von 75 cm bestrahlt, wobei die belichteten Teile des Photoresists und die darunterliegenden Teile des galvanisch abgeschiedenen Filmes zusammengehärtet werden. Das Laminat wird in eine 1 %-ige wässrige Lösung von $NaCO_3$ getaucht, wobei die unbelichteten Teile des Photoresists entfernt werden. Die dabei freiwerdenden Teile des galvanisch abgeschiedenen Films werden durch Eintauchen in 1,1,1-Trichlorethan herausgelöst. Das erhaltene Laminat hat ein Muster aus einer photogehärteten Lötstoppmaske, das mit dem darunterliegenden Kupfermuster und dem dazwischenliegenden gehärteten galvanisch abgeschiedenen Film fest verbunden ist.

Beispiel 3:

Ein mit dem Fotoresist RISTON® 3415 beschichtetes kupferkaschiertes Laminat wird bildhaft belichtet und ergibt nach dem Entwickeln ein Muster im Fotoresist. Das dadurch freiliegende Kupfer wird mit Zinn-Blei-Lötmetall bis zu einer Dicke von 7 µm galvanisiert. Das erhaltene Laminat wird als Kathode in einem galvanischen Bad verwendet, welches eine Anode aus rostfreiem Stahl und eine Lösung aus 100 Teilen Harz III, 40 Teilen 2-n-Butoxyethanol und 7,6 Teile einer 20-%igen wässrigen Milchsäure in 252,4 Teilen Wasser. Während 1 Minute wird eine Spannung von 20 Volt angelegt und dann wird das Laminat aus dem Bad entfernt, in Wasser gespült und während 5 Minuten bei 110°C getrocknet. Der galvanisch abgeschiedene Film bedeckt die Stellen, wo sich das Zinn-Blei-Lötmetall befindet. Das getrocknete Laminat wird in ein Bad mit dem Filmabstreifer bei 50°C getaucht. Bei dieser Behandlung wird der Fotoresist entfernt, während der galvanisch abgeschiedene Film zurückbleibt. Das nun freiliegende Kupfer wird durch Eintauchen in ein Aetzbad, enthaltend eine Lösung aus 150 Teilen Ammoniumpersulfat in 850 Teilen Wasser, bei 50°C entfernt. Das geätzte Laminat wird mit Wasser gewaschen und getrocknet. Man erhält auf dem Laminat ein klares Muster bestehend aus den auf dem Kupfer galvanisch abgeschiedenen Lötmetall und Film. Mittels einer Spiralrakel wird eine Schicht aus dem Epoxidharz, das zur Herstellung von Harz III verwendet wird, in einem organischen Lösungsmittel als Lötstoppmaske auf das mit Lötmetall überzogene Kupfermuster aufgetragen. Die Lötstoppmaskenschicht wird 5 Minuten bei 110°C getrocknet und dann durch eine transparente, ein Bild enthaltende Schablone unter Verwendung einer 5 kW Metallhalogenlampe im Abstand von 75 während 1 Minute bestrahlt. Dabei werden die beschichteten Teile des Lötstoppmaskenresists mit den darunterliegenden Teilen des galvanisch abgeschiedenen Harzes zusammen gehärtet. Das bestrahlte Laminat wird in eine Mischung aus 50 Teilen Propylencarbonat, 20 Teilen γ-Butyrolacton und 50 Teilen Diethylenglykolmonobutylether getaucht, wobei die nichtbelichteten Teile der Lötstoppmaske und die dabei blossgelegten Teile des galvanisch abgeschiedenen Harzes entfernt werden. Das erhaltene Laminat hat ein Muster aus einer fotogehärteten Lötstoppmaske, das mit dem darunterliegenden Kupfermuster durch den dazwischenliegenden gehärteten galvanisch abgeschiedenen Film fest verbunden ist.

Beispiel 4:

Ein mit dem Fotoresist RISTON® 3415 beschichtetes kupferkaschiertes Laminat wird bildhaft belichtet und nach dem Entwickeln wird ein Muster im Fotoresist erhalten. Dieses Laminat dient in einem galvanischen Bad als Kathode, welches eine Anode aus rostfreiem Stahl enthält. Dieses Bad enthält ausserdem eine Lösung aus 100 Teilen Harz IV, 17,1 Teilen einer 20%-igen wässrigen Milchsäure und 11,7 Teilen Triphenylsulfoniumhexafluoroantimonat in einer Mischung aus 23,3 Teilen 2-n-Butoxyethanol und 428,4 Teilen Wasser. Während 1 Minute wird ein Strom von 5 Volt durch das Bad geschickt und das Laminat wird dann dem Bad entnommen, mit Wasser abgespült und während 5 Minuten bei 110°C getrocknet. Der galvanisch abgeschiedene Film bedeckt die Stelle, an denen sich blossgelegtes Kupfer befand. Das getrocknete Laminat wird in eine 7%-ige wässrige Ethanollösung eingetaucht, wobei der Fotoresist abgelöst wird, während der galvanisch abgeschiedene Film haften bleibt. Das dabei freigelegte Kupfer wird durch Eintauchen in ein Aetzbad aus Eisenchloridlösung bei 30°C weggeätzt. Das Laminat wird in Wasser

gespült und getrocknet. Man erhält auf dem Laminat ein Klares Muster bestehend aus dem auf dem Kupfer galvanisch ausgeschiedenen Film. Eine 15 µm dicke Schicht aus 3,4-Epoxycyclohexylmethyl-3′,4′-cyclohexan-carboxylat enthaltend 5 Gew.-% Triphenylsulfoniumhexafluoroantimonat wird mittels einer Spiralrakel auf die Oberfläche des Kupfermusters aufgetragen. Diese wird während 10 Minuten durch eine transparente, ein Bild enthaltende Schablone unter Verwendung einer 5 kW Metallhalogenlampe im Abstand von 75 cm bestrahlt, wobei die belichteten Teile der Epoxidharzschicht und die darunter liegenden Teile des galvanisch abgeschiedenen Filmes zusammenhärten. Das belichtete Laminat wird in eine Mischung aus 50 Teilen Propylencarbonat, 20 Teilen γ-Butyrolacton und 30 Teilen Diethylenglykolmonobutylether getaucht, um die nichtbeleuchteten Teile der Lötstoppmaske und die dabei blossgelegten Teile des galvanisch abgeschiedenen Filmes zu entfernen. Das erhaltene Laminat hat ein Muster aus einem fotogehärteten Resist, das mit dem darunterliegenden Kupfermuster durch den dazwischenliegenden gehärteten galvanisch abgeschiedenen Film fest verbunden ist.

## Ansprüche

1. Ein Verfahren zur Herstellung eines Musters aus einem elektrisch leitfähigen Material, gekennzeichnet durch

(i) galvanisches Abscheiden eines Filmes enthaltend ein photohärtbares organisches Harz auf eine elektrisch leitende Oberfläche,

(ii) Ausbilden eines vorbestimmten Musters eines Resists auf dem galvanisch abgeschiedenen Film, welches beim Belichten mit aktinischen Strahlen mit den darunterliegenden Bereichen des galvanisch abgeschiedenen Filmes zusammen gehärtet wird, und wobei vorbestimmte Bereiche des galvanisch abgeschiedenen Filmes vom Resist unbedeckt bleiben.

(iii) Entfernen der unbedeckten Bereiche des galvanisch abgeschiedenen Filmes durch Behandeln mit einem Lösungsmittel dafür, wobei eine Oberfläche entsteht, die in vorbestimmten Bereichen freiliegendes leitfähiges Material aufweist und in anderen vorbestimmten Bereichen den photogehärteten Resist enthält, der durch den dazwischenliegenden, in bestimmten Bereichen galvanisch abgeschiedenen Film fest mit dem leitfähigen Material verbunden ist.

2. Verfahren gemäss Anspruch 1, worin der galvanisch abgeschiedene Film und der Photoresist durch Bestrahlen mit aktinischem Licht gehärtet werden, wobei photoempfindliche Gruppen die Vernetzung bewirken.

3. Verfahren gemäss Anspruch 2, worin der galvanisch abgeschiedene Film ein Reaktionsprodukt aus einem Epoxidharz, welches eine α,β-ethylenisch ungesättigte Ketongruppe enthält und worin die aromatischen oder ethylenisch ungesättigten Bindungen in Konjugation mit der α,β-Doppelbindung stehen, und einem sekundären Monoamin enthält und worin der Resist ein Epoxidharz mit der oben angegebenen konjugierten ungesättigten Ketongruppe enthält.

4. Verfahren gemäss Anspruch 3,worin das Epoxidharz ein Polyglycidylether von 1,5-Bis-(hydroxyphenyl)-penta-1,4-dien-3-on, ein daraus durch Vorverlängerung mit einem Bisphenol oder Hydantoin erhaltenes Reaktionsprodukt oder ein durch Vorverlängerung erhaltenes Reaktionsprodukt aus einem Bisphenoldiglycidylether oder einem N,N′-Diglycidylhydantoin mit einem 1,5-Bis-(hydroxyphenyl)-penta-1,4-dien-3-on ist.

5. Verfahren gemäss Anspruch 1, worin der galvanisch abgeschiedene Film und der Resist durch freie Radikale-Polymerisation gehärtet wird, wobei der galvanisch abgeschiedene Film und/oder der Resist einen Initiator für die freie Radikale-Polymerisation enthält.

6. Verfahren gemäss Anspruch 5, worin der galvanisch abgeschiedene Film eine polymerisierbare Acrylatgruppe zusammen mit einer ein Salz bildende Gruppe enthält.

7. Verfahren gemäss Anspruch 5, worin der galvanisch abgeschiedene Film eine Mischung aus einem Acrylatpolymer mit Carboxyl- und/oder tertiären Aminogruppen und einem Monomer mit wenigstens zwei Acrylat- oder Methacrylatgruppen enthält.

8. Verfahren gemäss Anspruch 6, worin der Resist eine Verbindung enthält, welche durchschnittlich mehr als eine polymerisierbare Acrylatgruppe im Molekül aufweist.

9. Verfahren gemäss Anspruch 8, worin der Resist in wässrigem Alkali entwickelbar ist und polymerisierbare Acrylatgruppen und wenigstens eine Carboxylgruppe enthält.

10. Verfahren gemäss Anspruch 1, worin der galvanisch abgeschiedene Film und der Resist mittels kationischer Polymerisation in Gegenwart eines kationischen Polymerisationsinhibitor gehärtet sind.

11. Verfahren gemäss Anspruch 10, worin der galvanisch abgeschiedene Film ein Harz enthält, das durch Umsetzung eines sekundären Monoamins mit einem Teil der Glycidylgruppen eines Copolymers

erhalten wird, wobei das Copolymer aus einem Monoacrylat enthaltend eine Glycidylgruppe und mindestens einem anderen Vinylmonomeren hergestellt wird.

12. Verfahren gemäss Anspruch 11, worin der Resist ein Epoxidharz zusammen mit einem Oniumsalz, einem Metalloceniumsalz oder einem aromatischen Jodosylsalz enthält.

13. Verfahren gemäss Anspruch 1, in welchem der Verfahrensschritt (ii) ausgeführt wird durch

(a) Aufbringen einer Schicht aus dem Resist auf dem galvanisch abgeschiedenen Film,

(b) Bestrahlen der Resistschicht mit aktinischem Licht in einem vorbestimmten Muster, wobei der Resist und der darunterliegende galvanisch abgeschiedene Film in den bestrahlten Bereichen gehärtet wird, und

(c) entfernen der nichtbestrahlten Bereiche der Resistschicht.

14. Ein für das Verfahren gemäss Anspruch 1 geeignetes galvanisch abscheidbares, photohärtbares Harz, das ein Reaktionsprodukt aus

(A) einem Epoxidharz enthaltend eine $\alpha,\beta$-ethylenisch ungesättigte Ketongruppe, wobei die aromatischen oder ethylenisch ungesättigten Doppelbindungen in Konjugation mit der $\alpha,\beta$-Doppelbindung stehen, und (B) einem sekundären Monoamin.

15. Harz gemäss Anspruch 14, worin das sekundäre Monoamin ein Alkanolamin ist.

16. Harz gemäss Anspruch 14, das der Formel I

$R_1[CH_2CH(OH)CH_2N(R_2)R_3]_2$ (I),

worin $R_1$ einen Rest eines Epoxidharzes nach Entfernen von zwei Epoxidgruppen darstellt, der eine $\alpha,\beta$-ethylenisch ungesättigte Ketongruppe enthält und worin die aromatische und ethylenische Doppelbindung in Konjugation zur $\alpha,\beta$-Doppelbindung stehen, $R_2$ und $R_3$ je ein unsubstituiertes oder durch eine Hydroxylgruppe substituiertes $C_1$-$C_{12}$-Alkyl bedeuten oder worin $R_2$ und $R_3$ zusammen mit dem angegebenen N-Atom einen 5- oder 6-gliedrigen heterocyclischen Ring darstellen.

17. Harz gemäss Anspruch 16, worin $R_1$ in Formel I den Rest eines Epoxidharzes bedeutet, welcher mindestens eine Gruppe der Formel II

$-O-Ar_1-CH=CH-CO-CH=CH-Ar_1-O-$ (II),

enthält, worin $Ar_1$ einen unsubstituierten oder substituierten Phenylenrest bedeutet.

18. Harz gemäss Anspruch 17, worin $R_1$ einen Rest der Formel III oder IV

$\{\{XCH_2CH(OH)CH_2)_m-(YCH_2CH(OH)CH_2)_n\}_p-X-$ (III) oder

$\{\{YCH_2CH(OH)CH_2)_n-(XCH_2CH(OH)CH_2)_m\}_p-Y-$ (IV),

darstellt, worin X einen Rest der Formel II bedeutet, worin $A_1$ für einen unsubstituierten Phenylenrest steht, Y einen Rest der Formel V oder VI

$-O-Ar_2-R_4-Ar_2-O-$ (V)

oder

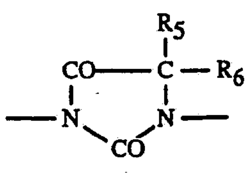

(VI)

bedeutet, worin $Ar_2$ einen unsubstituierten oder substituierten Phenylenrest bedeutet, $R_2$ und $R_3$ je ein hydroxylsubstituiertes Alkyl mit 2 bis 4 Kohlenstoffatomen, $R_4$ ein Alkylen mit 1 bis 3 Kohlenstoffatomen und $R_5$ und $R_6$ je ein Wasserstoffatom oder Alkyl mit 1 bis 4 Kohlenstoffatomen bedeuten und m, n und p positive Zahlen darstellen, so dass das Harz ein Molekulargewicht von 500 bis 10'000 aufweist.